# EUROPÄISCHE PATENTSCHRIFT

(11) **EP 0 559 855 B1**
(45) Veröffentlichungstag und Bekanntmachung des Hinweises auf die Patenterteilung: **22.05.1996**
(21) Anmeldenummer: 92918725.0
(22) Anmeldetag: 07.09.1992
(51) Int. Cl.: H05K 7/12, H05K 7/20

(54) **FLACHBAUGRUPPE**
FLAT MODULE
MODULE PLAT

(30) Priorität: 27.09.1991 DE 9112099 U
(43) Veröffentlichungstag der Anmeldung: 15.09.1993
(73) Patentinhaber: Siemens Nixdorf Informationssysteme Aktiengesellschaft, D-33102 Paderborn (DE)
(72) Erfinder: WESSELY, Hermann, D-8000 München 60 (DE); BRABETZ, Bernhard, D-8025 Unterhaching (DE)
(74) Vertreter: Fuchs, Franz-Josef, Dr.-Ing.
(86) Internationale Anmeldenummer: DE9200754
(87) Internationale Veröffentlichungsnummer: WO9306703

(56) Entgegenhaltungen:
- EP-A- 0 191 270
- EP-A- 0 226 042
- EP-A- 0 338 447
- WO-A-92/02117
- US-A- 3 225 262

## Beschreibung

Bei Planarbaugruppen ist es bekannt, gehäuselose Bausteine (Chips) auf der Oberfläche der Baugruppenleiterplatte (z.B. Mikroverdrahtungsleiterplatte) zu montieren und dabei zwischen Leiterplatte und Baustein ein elastisches Druckstück einzulegen, welches die Aufgabe hat, die Oberfläche des Chips zum Zwecke der Wärmeabfuhr an eine Kühlplatte zu drücken. Um ein ausreichendes Federungsverhalten zu erreichen, ist es daher notwendig, das elastische Druckstück zwischen Chip und der Mikroverdrahtungsplatte entsprechend dick zu dimensionieren. Das hat aber zur Folge, daß die Z-Biegung der Anschlußbeinchen des Bausteins größer gemacht werden muß, als sie eigentlich zum Ausgleich der Thermospannungen benötigt würde. Je größer jedoch diese Z-Biegung ist, desto größer sind auch die Toleranzen im Oberflächenlötbereich der Anschlußbeinchen und der Mikroverdrahtungsplatte.

Aus EP-A-0 226 042 ist eine Anordnung bekannt, bei der ein elastisches Druckstück verwendet wird, um einen Baustein seitlich gegen eine Seitenwand einer Einsenkung einer Trägerplatte zu drücken. Wirkt das elastische Druckstück schon seitlich auf den Baustein, so kommt noch hinzu, daß die Trägerplatte als Kühlplatte ausgebildet ist und der Baustein über einen wärmeleitenden Sockel auf der Kühlplatte aufliegt. Ferner handelt es sich bei dem Druckstück um ein blattfederahnliches Gebilde.

Aus EP-A-0 191 270 ist ein Druckstück bekannt, das in einer Einsenkung einer Grundplatte fest angeordnet ist und den Baustein von der Grundplatte wegdrückt. Bei dem Druckstück handelt es sich aber ebenfalls um ein blattfederähnliches Gebilde.

Aufgabe der vorliegenden Neuerung ist es, eine Anordnung anzugeben, durch die die zwei entgegenlaufenden Forderungen, nämlich möglichst dickes Druckstück und möglichst kleine Z-Biegung der Anschlußbeinchen realisiert werden kann.

Diese Aufgabe wird durch die kennzeichnenden Merkmale des Patentanspruchs gelöst.

Durch diese Maßnahmen wird erreicht, daß die Toleranzen im Oberflächenlötbereich verkleinert werden, ohne daß der Wärmeübergang zwischen Baustein und Kühlplatte beeinträchtigt wird.

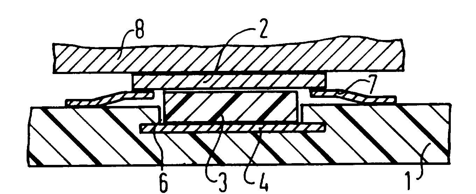

Anhand des Ausführungsbeispiels nach der Figur wird die Neuerung näher erläutert.

Auf der Mikroverdrahtungsleiterplatte 1 sind Einsenkungen 6 vorgesehen, in die das elastische Druckstück 3 einlegbar ist, wobei die untere Auflagefläche des Druckstückes die nächstfolgende Kupferebene 4 der Mikroverdrahtung ist. Dadurch wird der Abstand zwischen unterer Oberfläche des Bausteins 2 und der Oberfläche der Mikroverdrahtungsplatte verringert, so daß die Z-förmige Biegung der Anschlußbeinchen 7 verringert werden kann. Trotzdem bleibt der gute Kontakt der Oberfläche des Bausteins 2 mit der Kühlplatte 8 erhalten.

## Patentansprüche

1. Flachbaugruppe, bestehend aus einer Leiterplatte und auf ihr oberflächenmontierten gehäuselosen Bausteinen mit einem elastischen Druckstück zwischen Leiterplatte und Baustein, wobei auf der Oberfläche der Leiterplatte (1) Einsenkungen (6) zur Aufnahme der Druckstücke (3) vorgesehen sind und das Druckstück (3) und die Einsenkung (6) gegenseitig derart geformt sind, daß das Druckstück (3) lose in der Einsenkung (6) unterhalb des Bausteins (2) liegt und dabei einen uniformen Druck auf die Unterseite des Bausteins (2) ausübt, so daß die Oberfläche des Bausteins (2) gut gegen eine Kühlplatte (8) gedrückt wird.

## Claims

1. Flat module, consisting of a circuit board and unpackaged chips surface-mounted on this board, with an elastic pressure pad between circuit board and chip, depressions (6) for accommodating the pressure pads (3) being provided on the surface of the circuit board (1), and the pressure pad (3) and the depression (6) being mutually shaped such that the pressure pad (3) lies loosely in the depression (6) under the chip (2) and at the same time exerts a uniform pressure on the underside of the chip (2), with the result that the surface of the chip (2) is pressed well against a cooling plate (8).

## Revendications

1. Module plat, constitué d'une plaquette à circuits imprimés et de composants sans boîtier montés en surface sur cette plaquette et comportant une pièce élastique de pression entre la plaquette à circuits imprimés et un composant, des évidements (6) pour la réception des pièces (3) de pression étant prévus sur la surface de la plaquette (1) à circuits imprimés et la pièce (3) de pression et l'évidement (6) étant formés l'un par rapport à l'autre, de telle sorte que la pièce (3) de pression soit lâche dans l'évidement (6) en-dessous du composant (2) et y exerce une pression uniforme sur la face inférieure du composant (2), de sorte que la surface du composant (2) soit bien appuyée sur une plaquette (8) de refroidissement.
